# EUROPÄISCHE PATENTANMELDUNG

(11) **EP 2 256 929 A1**
(43) Veröffentlichungstag der Anmeldung: **01.12.2010**
(21) Anmeldenummer: 09007178.8
(22) Anmeldetag: 29.05.2009
(51) Int. Cl.: H03K 17/18, H01H 9/16, H03K 5/1254, H03K 5/12

(54) **Elektrisches Modul**

(71) Anmelder: Murrelektronik GmbH, 71570 Oppenweiler (DE)
(72) Erfinder: Rödiger, Jonny, 71540 Murrhardt (DE); Bauermeister, Ralf, 71720 Oberstenfeld (DE)
(74) Vertreter: Riedel, Peter

(57) **Zusammenfassung**

Ein elektrisches Modul weist mindestens einen digitalen Eingang (I) für einen Sensor (2) mit einem schaltenden Kontakt (4) auf. Dabei ist an den Eingang (I) ein elektrisches Bauteil (9) geschaltet, das einen durch den Sensor (2) bei geschlossenem Kontakt (4) fließenden Strom begrenzt. Um einen wesentlich schnelleren Übergang zwischen den digitalen Zuständen "HIGH" und "LOW" zu erhalten, ist eine elektrische Schaltung (10) vorgesehen, die an den Eingang (I) angeschlossen ist und die beim Öffnen des Kontaktes (4) im Sensor (2) den Eingang (I) mit einem Masse- oder Erdpotenzial (11) kurzschließt.

## Beschreibung

Die Erfindung betrifft ein elektrisches Modul, mit mindestens einem digitalen Eingang für einen Sensor der im Oberbegriff des Anspruchs 1 angegeben Gattung.

An digitale Eingänge von elektrischen Modulen werden oft Sensoren geschaltet, die einen schaltenden Kontakt umfassen. Bei geschlossenem Kontakt des Sensors zieht dieser über den Eingang am Modul einen Strom, der durch ein an den Eingang geschaltetes elektrisches Bauteil auf einen bestimmten Wert begrenzt wird, beispielsweise 6 mA. Fließt ein Strom in dieser Größe, ist der Zustand am Eingang, an dem der Sensor angeschlossen ist, "HIGH". Öffnet der Schaltkontakt im Sensor, ergibt sich oft kein Aus-Zustand, sondern meist ein hochohmiger Zustand, da der Eingang am Modul aufgrund der Anschlussleitungen des Sensors stark kapazitiv belastet ist. Somit fließt über den hochohmigen Widerstand, den der Sensor mit den Anschlussleitungen bildet, noch ein Strom, wodurch sich das am Eingang liegende Potenzial nur allmählich verringert, was in der Zeit des Übergangs vom Zustand "HIGH" zum Zustand "LOW" ein undefiniertes Potenzial darstellt. Diese Abfallzeit von "HIGH" auf "LOW", kann beispielsweise 30 µs betragen. Zwar könnte eine größere Flankensteilheit mit einem deutlich höheren Eingangsstrom von z.B. 30 mA erreicht werden, dies hätte jedoch den Nachteil, dass im Schaltzustand "HIGH" die Schaltung einen großen Eingangsstrom zieht und die Schaltung sich somit erwärmt und unnötige Verlustleistung produziert.

Der Erfindung liegt die Aufgabe zugrunde, ein gattungsgemäßes elektrisches Modul zu schaffen, bei dem im Falle des Öffnens des Sensorkontaktes wesentlich schneller das Potenzial bzw. Signal "LOW" erreicht wird.

Diese Aufgabe wird durch ein elektrisches Modul mit den Merkmalen des Anspruchs 1 gelöst.

Durch die elektrische Schaltung wird beim Öffnen des Schaltkontaktes das Signal am Eingang aktiv auf das Potenzial "LOW" gezogen, wodurch eine entsprechend steile Flanke beim Umschalten von "HIGH" auf "LOW" erzielt wird. Dadurch reduziert sich die Abfallzeit von "HIGH" auf "LOLV" wesentlich, wobei diese bei ca. 0,5 µs liegt. Somit wird äußerst schnell ein Zustand erreicht, den eine Auswerteelektronik sicher erkennt. Die Flankensteilheit führt zu einer schnellen Kommunikation zwischen Sensor und Eingangsmodul. Diese Kommunikation kann auch bidirektional ausgeführt sein, wodurch das Eingangsmodul (Daten empfangen) auch als Ausgangsmodul (Daten senden) auf dem selben Pin (Anschluss) funktioniert.

Als Sensor kommen sowohl aktive als auch passive Sensoren in Betracht. Als aktiver Sensor kann auch ein Aktor vorgesehen sein. Es ist zweckmäßig, das den durch den Sensor fließenden Strom begrenzende Bauteil und die elektrische Schaltung parallel zwischen eine Signalleitung und ein Massepotenzial zu schalten. Die elektrische Schaltung umfasst vorzugsweise einen Komparator und einen Schalttransistor, wobei der Schalttransistor im durchgesteuerten Zustand den Eingang mit dem Massepotenzial kurzschließt. Der Ausgang des Komparators ist bevorzugt über einen Kondensator mit der Basis des Schalttransistors verbunden. Um möglichst schnell eine Änderung des Eingangssignals zu erfassen, ist ein nicht invertierender Eingang des Komparators über eine Zenerdiode mit einem Versorgungsanschluss und ein invertierender Eingang unmittelbar an die Signalleitung angeschlossen.

Die Erfindung ist nachstehend anhand eines Ausführungsbeispiels näher erläutert. In der Zeichnung zeigt:
- Fig. 1: eine schematische Darstellung eines Moduls mit einem angeschlossenen Sensor,
- Fig. 2: ein Schaltbild eines Teils des Moduls mit ange- schlossenem Sensor,
- Fig. 3a: den Signalverlauf beim Öffnen des Sensorkontaktes ohne aktiven Potenzialausgleich,
- Fig. 3b: den Signalverlauf beim Öffnen des Sensorkontaktes mit aktivem Potenzialausgleich,
- Fig. 4: ein Schaltbild mit einem Komparator und einem Schalttransistor.

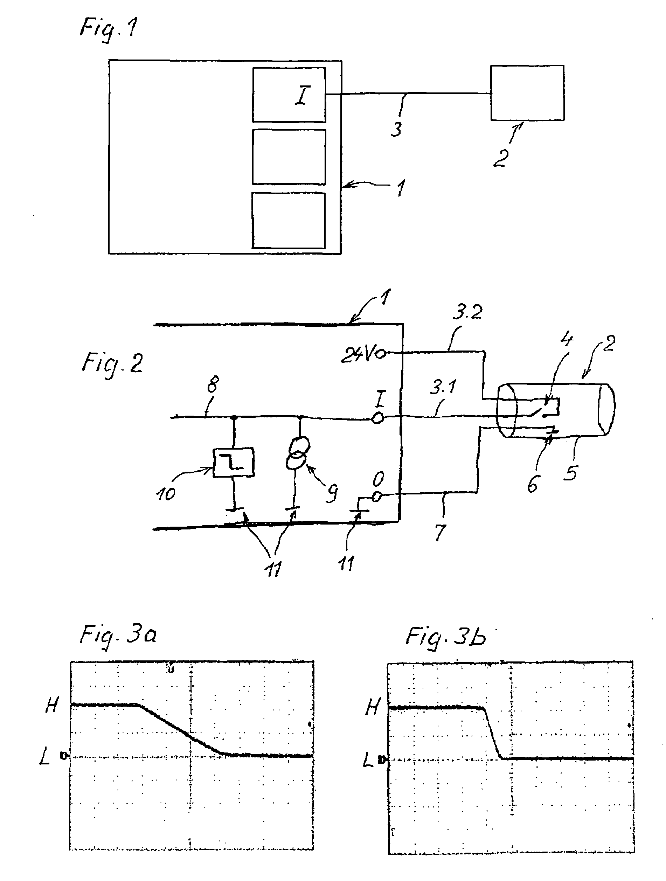

In Fig. 1 sind schematisch ein Modul 1 und ein Sensor 2 dargestellt, wobei der Sensor 2 mittels einer Verbindungsleitung 3 an einen Eingang I des Moduls 1 angeschlossen ist. Bei dem Sensor 2 kann es sich beispielsweise um einen Näherungsschalter oder Drucksensor handeln.

Die Fig. 2 zeigt ein Schaltbild eines Teils des Moduls 1 mit dem Sensor 2. Der Sensor 2 besitzt ein Gehäuse 5 mit einem darin angeordneten Schaltkontakt 4. Dieser Schaltkontakt 4 ist einerseits über einen Leiter 3.1 an den Eingang I und andererseits mit einem Leiter 3.2 an einen Versorgungsanschluss, beispielsweise eine 24 V Klemme des Moduls 1 angeschlossen. Im Gehäuse 5 des Sensors 2 ist ein Massekontakt 6 vorgesehen, der über eine Verbindungsleitung 7 an eine Massenklemme 0 des Moduls 1 angeschlossen ist, die wiederum mit dem Masse- oder Erdungspotenzial 11 verbunden ist. An den Eingang I ist eine innerhalb des Moduls 1 verlaufende Signalleitung 8 angeschlossen. Zwischen die Signalleitung 8 und das Massepotenzial 11 ist ein Bauteil 9 geschaltet, das bei geschlossenem Schaltkontakt 4 des Sensors 2 und somit dem digitalen Zustand "HIGH" einen Strom von ca. 6 mA fließen lässt. Außerdem ist zwischen die Signalleitung 8 und das Massepotenzial 11 eine Schaltung 10 eingesetzt.

Öffnet der Sensorkontakt 4, so würde der Eingang I ohne die Schaltung 10 auf einem undefinierten Potenzial liegen. Aufgrund der Anschlussleitung 3.1, 3.2 des Sensors 2 ist der Eingang I sehr stark kapazitiv belastet, weshalb sich der Spannungszustand "HIGH" nur langsam über den Widerstand des Bauteils 9, der den Eingangsstrom auf 6 mA begrenzt, abbaut.

Dieser Verlauf des Übergangs von dem digitalen Signal "HIGH" H auf das Signal "LOW" L ist in Fig. 3a dargestellt. Daraus ist ersichtlich, dass das Signal nur allmählich vom Zustand H in den Zustand L übergeht.

Durch die Schaltung 10 wird erreicht, dass diese beim Öffnen des Schaltkontaktes 4 im Sensor 2 die Signalleitung 8 über die Schaltung 10 mit dem Massepotenzial 11 kurzschließt und somit das Potenzial am Eingang I aktiv auf "LOW" zieht. Dieser Wechsel vom Potenzial H zum Potenzial L mit Hilfe der Schaltung 10 ist in Fig. 3b dargestellt. Es ist daraus ersichtlich, dass beim Öffnen des Schaltkontaktes 4 ein sehr schneller Wechsel vom Zustand des digitalen Signals H zum Signal L mit einer sehr steilen Flanke erfolgt, und damit in viel kürzerer Zeit, als dies ohne die Erfindung der Fall wäre.

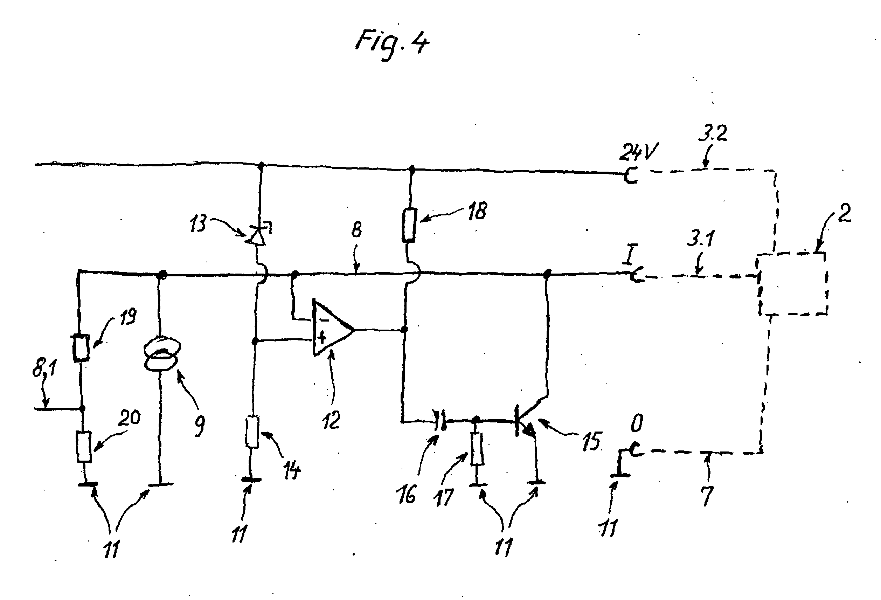

In Fig. 4 ist ein Schaltbild dargestellt mit einem Beispiel zur Ausführung der Schaltung 10 in Fig. 2. Die Erfindung ist jedoch nicht auf dieses Beispiel beschränkt, sondern kann auch mit anderen Schaltungen realisiert werden. In Fig. 4 ist der Sensor 2 mit seinen Anschlussleitungen 3.1 und 3.2 sowie der Verbindungsleitung 7 durch gestrichelte Linien angedeutet. Es kann sich dabei um einen passiven Sensor oder aktiven Sensor handeln, in letzterem Fall auch um einen Aktor. Die Schaltung zum Kurzschließen des Eingangs I mit dem Masse- oder Erdungspotenzial 11 umfasst im Wesentlichen einen Komparator 12 und einen Schalttransistor 15. Der nicht invertierende Eingang des Komparators 12 ist über eine Zenerdiode 13 mit dem Versorgungsanschluss, d.h. der 24 V Klemme und über einen Widerstand 14 mit dem Masse- oder Erdungspotenzial verbunden. Der invertierende Eingang des Komparators 12 liegt an der Signalleitung 8. Der Ausgang des Komparators 12 ist über einen Entkopplungskondensator 16 an die Basis des Schalttransistors 15 geschaltet und über einen Widerstand 18 mit dem Versorgungsanschluss verbunden. Zwischen der Basis des Schalttransistors 15 und dem Masse- oder Erdungspotenzial 11 befindet sich ein Widerstand 17. Der Kollektor des Schalttransistors 15 ist mit dem Eingang I verbunden und der Emitter an das Masse- oder Erdungspotenzial 11 angeschlossen. In der Signalleitung 8, 8.1 befindet sich ein aus zwei Widerständen 19 und 20 gebildeter Spannungsteiler.

Am Sensor 20 liegt eine Spannung U_{Sens} und an der Zenerdiode eine Spannung U_{ZDiode}. Beim Öffnen des Sensorkontaktes ändert sich die Spannung am Eingang I. Der Komparator 12 schaltet, sobald die Spannung am Eingang I kleiner ist als die Differenz aus U_{Sens} - U_{ZDiode}. Dann wird vom Ausgang des Komparators 12 ein kurzer Impuls über den Kondensator 16 auf die Basis des Schalttransistors 15 gegeben, so dass dieser durchschaltet und damit einen Kurzschluss zwischen dem Eingang I und dem Masse- oder Erdungspotenzial 11 erzeugt. Damit fällt die Spannung am Eingang I schlagartig ab. Das Signal wird nur beim Wechsel vom Spannungszustand "HIGH" nach "LOW" kurzgeschlossen. Im statischen Zustand "HIGH" oder "LOW" hat die Schaltung keine Auswirkung auf den Strom am Eingang I. Das beschriebene Beispiel ist für PNP-Sensoren (Plus-schaltend). Selbstverständlich ist es auch möglich, eine angepasste Schaltung für NPN-Sensoren (Minus-schaltend) einzusetzen.

## Patentansprüche

1. Elektrisches Modul mit mindestens einem digitalen Eingang (I) für einen Sensor (2), der einen schaltenden Kontakt (4) aufweist, wobei an den Eingang (I) ein elektrisches Bauteil (9) geschaltet ist, das einen durch den Sensor (2) bei geschlossenem Kontakt (4) fließenden Strom begrenzt, **dadurch gekennzeichnet, dass** eine elektrische Schaltung (10) vorgesehen ist, die an den Eingang (I) angeschlossen ist und die beim Öffnen des Kontaktes (4) im Sensor (2) den Eingang (I) mit einem Masse- oder Erdpotenzial (11) kurzschließt.

2. Modul nach Anspruch 1,
**dadurch gekennzeichnet, dass** der Sensor (2) ein aktiver oder passiver Sensor ist.

3. Modul nach Anspruch 2,
**dadurch gekennzeichnet, dass** als aktiver Sensor ein Aktor vorgesehen ist.

4. Modul nach einem der Ansprüche 1 bis 3,
**dadurch gekennzeichnet, dass** das den durch den Sensor (2) fließenden Strom begrenzende Bauteil (9) und die elektrische Schaltung (10) parallel zwischen eine Signalleitung (8) und ein Massenpotenzial (11) geschaltet sind.

5. Modul nach Anspruch 4,
**dadurch gekennzeichnet, dass** die elektrische Schaltung (10) zumindest einen Komparator (12) und einen Schalttransistor (15) umfasst, wobei der Schalttransistor in durchgesteuertem Zustand den Eingang (I) mit dem Masse- oder Erdungspotenzial (11) kurzschließt.

6. Modul nach Anspruch 5,
**dadurch gekennzeichnet, dass** ein Ausgang des Komparators (12) über einen Kondensator (16) mit der Basis des Schalttransistors verbunden ist.

7. Modul nach Anspruch 5 oder 6,
**dadurch gekennzeichnet, dass** ein nicht invertierender Eingang des Komparators (12) über eine Zenerdiode (13) mit einem Versorgungsanschluss verbunden und ein invertierender Eingang unmittelbar an die Signalleitung (8) angeschlossen ist.

## Geänderte Patentansprüche

### Geänderte Patentansprüche gemäss Regel 137(2) EPÜ.

**1.** Elektrisches Modul mit mindestens einem digitalen Eingang (I) für einen Sensor (2), der einen schaltenden Kontakt (4) aufweist, wobei an den Eingang (I) ein elektrisches Bauteil (9) geschaltet ist, das einen durch den Sensor (2) bei geschlossenem Kontakt (4) fließenden Strom begrenzt, wobei eine elektrische Schaltung (10) vorgesehen ist, die an den Eingang (I) angeschlossen ist und die beim Öffnen des Kontaktes (4) im Sensor (2) den Eingang (I) mit einem Masse- oder Erdpotenzial (11) kurzschließt, wobei das den durch den Sensor (2) fließenden Strom begrenzende Bauteil (9) und die elektrische Schaltung (10) parallel zwischen eine Signalleitung (8) und ein Massenpotenzial (11) geschaltet sind,
**dadurch gekennzeichnet, dass** die elektrische Schaltung (10) zumindest einen Komparator (12) und einen Schalttransistor (15) umfasst und dass ein Ausgang des Komparators (12) über einen Kondensator (16) mit der Basis des Schalttransistors verbunden ist, wobei der Schalttransistor in durchgesteuertem Zustand den Eingang (I) mit dem Masse- oder Erdungspotenzial (11) kurzschließt.

**2.** Modul nach Anspruch 1,
**dadurch gekennzeichnet, dass** ein nicht invertierender Eingang des Komparators (12) über eine Zenerdiode (13) mit einem Versorgungsanschluss verbunden und ein invertierender Eingang unmittelbar an die Signalleitung (8) angeschlossen ist.
